# EUROPEAN PATENT APPLICATION

(11) **EP 0 859 281 A1**
(43) Date of publication of application: **19.08.1998**
(21) Application number: 98200301.4
(22) Date of filing: 02.02.1998
(51) Int. Cl.: G03F 3/10, G03F 7/34, B41F 16/00, G03D 13/00

(54) **Carrier element useful for preparing prepress color proofs**

(30) Priority: 14.02.1997 US 800822
(71) Applicant: EASTMAN KODAK COMPANY, Rochester, New York 14650 (US)
(72) Inventor: Niemeyer, David Alan, c/o Eastman Kodak Company, Rochester, New York 14650-2201 (US); Campbell, Colin Carl, c/o Eastman Kodak Company, Rochester, New York 14650-2201 (US)
(74) Representative: Parent, Yves

(57) **Abstract**

A carrier element useful in a dry color proofing process has a relatively stiff substrate, and optionally a thermoplastic adhesive coating on one side. The element also has at least one surface that is convex symmetrically about the centerline of the element width, the ratio of the substrate centerline thickness to substrate edge thickness being from 1.05:1 to 2:1.

## Description

In general, this invention relates to the color proofing art, and in particular, to an improved carrier element useful in preparing prepress color proofs. It also relates to a method of using the carrier element to prepare a prepress color proof.

Prepress color proofing systems are in widespread use in the printing industry. In a typical process, a multicolor original is separated into individual transparencies, called color separations, for the three subtractive primaries and for black. The separation process can be carried out in a number of well-known ways. For example, a graphic arts scanner can be used to create the color separations. In some instances, more than four color separations are employed. A color proof, called an "off-press" proof or a "prepress" proof, is then prepared from the color separations. The color proof is used by the printer to check color balance and other important quality control parameters.

Generally speaking, prepress color proofs are one of three types: namely (1) a color overlay that employs an image on a separate base for each color, (2) a single integral sheet process in which the separate color images are combined on a single base, or (3) a digital method in which the images are produced directly on a single base from digital data. The overlay and single sheet process are described in some detail in, for example, US-A-4,895,787 which points out that the single sheet process is greatly preferred because the superposed supports of the overlay process drastically alter the appearance of the color proof.

US-A-3,622,320 describes a color proofing process of the single sheet type that is simple and convenient to use, and is a dry process that does not require the use of processing solutions. As described therein, the color-proofing process utilizes two or more light-sensitive donor elements, each of which contains a different dispersed colorant. The donor elements employ a light-sensitive resin that has a tackifying point that is raised by light exposure. That is, the resin is photohardenable. The imagewise-exposed donor element is pressed into contact with a receiver element while being heated to a temperature that is greater than the tackifying point in unexposed areas of the resin but less than the tackifying point in the exposed areas of the resin. Thus, the colored resin transfers from the unexposed areas to the receiver element. Second and subsequent donor elements, each containing a different colorant, are similarly exposed, and the image is transferred therefrom, in exact registration, to the same receiver element. For full color reproduction, it is customary to expose and transfer images from donor elements containing, respectively, black, cyan, magenta and yellow colorants. Commonly, the donor elements are exposed by use of a set of half-tone color separation positives.

Instead of using a photohardenable resin, acceptable results in a single sheet process can also be achieved by using a donor resin that is phototackifiable. With this type of resin, the exposed areas will be more tacky at the transfer temperature than the unexposed areas and, accordingly, the colored resin will transfer from the exposed areas to the receiver element. In this instance, the donor elements can be exposed by use of a set of half-tone color separation negatives. Phototackifiable compositions and their use in a single sheet process are described, for example, in US-A-5,108,868.

Whatever donor resin is used, the process of making a color proof requires heat to increase the difference in surface adhesion between exposed and unexposed areas of the donor element and pressure to bring about effective image transfer. For example, as described in US-A-5,374,497, the exposed donor element is placed in contact with the receiver element, the laminate that is so formed is passed between a pair of heated pressure rollers, and the donor element is then separated from the receiver element which then carries the transferred image. Separation of the donor element from the receiver element is usually accomplished by a manual peeling step, but can, if desired, be accomplished automatically by the laminator.

The noted laminate may be transported through the rollers as is, or superposed on a relatively stiff carrier element.

One problem associated with known dry color proofing processes, wherein sequential images must be transferred in register, relates to maintaining the register despite a high temperature lamination step. In the lamination step, at least one of the elements being laminated must be heated sufficiently to deliver suitable heat to the interface of the two elements. If the lamination temperature is above the glass transition temperature of the receiver or donor element support, an irreversible dimensional change will occur due to the relaxation of residual stresses within either element's support. Simple carrier plates known in the art, such as those described in US-A-5,374,497 (noted above), are not able to prevent this highly undesirable irreversible dimensional change.

Carrier plates that solve the noted problem with irreversible dimensional change are described in EP 97101315.6. These carrier plates comprise a relatively stiff substrate (such as an aluminum plate) having a thermoplastic adhesive coating on one side. This coating has a glass transition temperature that is less than the lamination temperature, but is sufficiently high to provide low surface tackiness at room temperature. The adhesive coating also exhibits sufficient surface tackiness at the lamination temperature to prevent irreversible dimensional change of the receiver element during the laminating step. Thus, such improved carrier plates can be used to make sure that the irreversible dimensional change (in either dimension) is very low, that is generally less than 0.01%, in either the donor or receiver element used in the laminating process.

When two roller laminating machines are used to make color proofs, however, it is not uncommon for the pressure applied to the nip to exceed the beam strength of one or both of the rollers, thereby causing one or both rollers to bow outward from the nip. 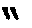 Beam strength*"* refers to the resistance to bending or deflection while under a load.

The noted problem results in a concave nip between the laminating rollers. That is, the nip width is greatest at the ends of the rollers and decreases symmetrically toward the center of the rollers. When lamination is carried out using a donor element and a receiver element on a carrier plate, any concave nip imparts a bow to the donor element in the laminate, dramatically increasing the difficulty in successfully registering subsequently laminated donor elements. The transferred image is therefore distorted and the color rendition is poor. Registration of the various donor elements is critical to having accurate color rendition in the eventual color proof.

Thus, there is a need for a way to overcome the problem arising from a concave nip without having to modify the laminating rollers or machine, or without having to sacrifice laminating pressure while achieving the desired image transfer with accurate registration.

The problem arising from a concave roller nip is overcome with a carrier element useful in a dry color proofing process in which a color image is transferred from a donor element to a receiver element by laminating the donor element to the receiver element at selected lamination temperature and pressure in a laminating device having matching laminating rollers that define a laminating nip, followed by peeling the laminated donor element from the receiver element,
the carrier element comprising a relatively stiff substrate having a width dimension,
the element characterized wherein the substrate has at least one surface thereof that is convex symmetrically about the centerline of the width dimension, wherein the ratio of the substrate centerline thickness to the substrate edge thickness in the width dimension is from 1.05:1 to 2:1.

This invention also provides a method for preparing a prepress color proof in which color images are successively transferred from donor elements to a receiver element by a process of lamination so as to form a multicolor image on the receiver element, the method comprising the steps of:
A) providing a receiver element,
B) providing at least two imagewise-exposed, multilayer donor elements, each of which contains a colorant that undergoes imagewise transfer to the receiver element, and
C) transferring a color image in either exposed or unexposed areas of each of the donor elements, by:
   laminating at selected lamination temperature and pressure, in succession and register, each of the donor elements to the receiver element in a laminating device, the laminating device having matching laminating rollers forming a laminating nip,
   followed by peeling each of the laminated donor elements from the receiver element,
      wherein each of the donor elements and the receiver element are carried through the laminating nip of the laminating device with a carrier element as described above.

This invention also provides for the use of the noted carrier plate in any suitable imaging process. The carrier element of this invention essentially compensates for the problem with a concave nip in the laminating rollers because the element is convex across its width dimension, and the convexity is symmetrical about the centerline of the width dimension. The increased thickness in the central portion of the element increases the pressure between the rollers in the area where the deflection of the rollers outward has caused a reduction in the pressure. The net result, if the effects are properly balanced, is a uniform pressure profile down the length of the rollers and therefore a nip of constant width which eliminates the bow in the transfer.

FIG. 1 is a cross-sectional view of a preferred carrier plate embodiment of this invention having a step-wise profile on one surface thereof.

FIG. 2 is a cross-sectional view of an additional carrier plate embodiment of this invention having a step-wise profile on one surface thereof.

FIG. 3 is a cross-sectional view of an additional carrier plate embodiment of this invention having a smooth profile on one surface thereof.

FIG. 4 is a cross-sectional view of still another carrier plate embodiment of this invention having a step-wise profile on both surfaces thereof.

FIG. 5 is a cross-sectional view of a preferred embodiment of the carrier plate of this invention that comprises a thermoplastic adhesive layer on one surface thereof.

FIG. 6 is a cross-sectional view of another embodiment of the carrier plate of this invention.

The carrier element of this invention comprises a relatively stiff substrate that does not undergo irreversible dimensional change. By 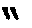 relatively stiff*"* is meant a modulus of elasticity greater than or equal to 8,000 ksi. Such substrates include, but are not limited to, metallic substrates (such as polished or roughened aluminum, steel and copper), polymeric sheets or films, paper card stock, and various composites. Metallic substrates, such as anodized aluminum substrates, are preferred.

The substrate of the carrier element has a width dimension, and in preferred embodiments, it is square or rectangular in shape. Alternatively, the carrier element can be an endless belt. A rectangular shaped substrate (and hence, carrier plate) is preferred. Generally, the width dimension is less than or equal to the length of the laminating rollers. Convexity is then provided in the substrate symmetrically about the centerline of the width dimension, and thus also generally symmetrical about the centerline of the laminating roller nip, and perpendicular to the rotational axis of the matching laminating rollers. Generally, the extent of the convexity in a given carrier element is desirably roughly complementary to the concavity produced in the laminating roller nip by the pressure applied thereto.

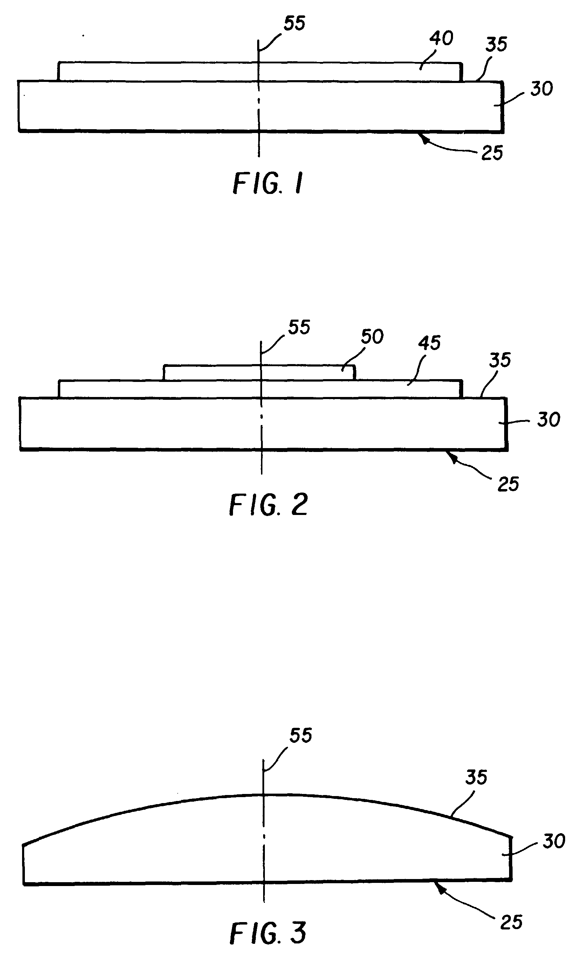

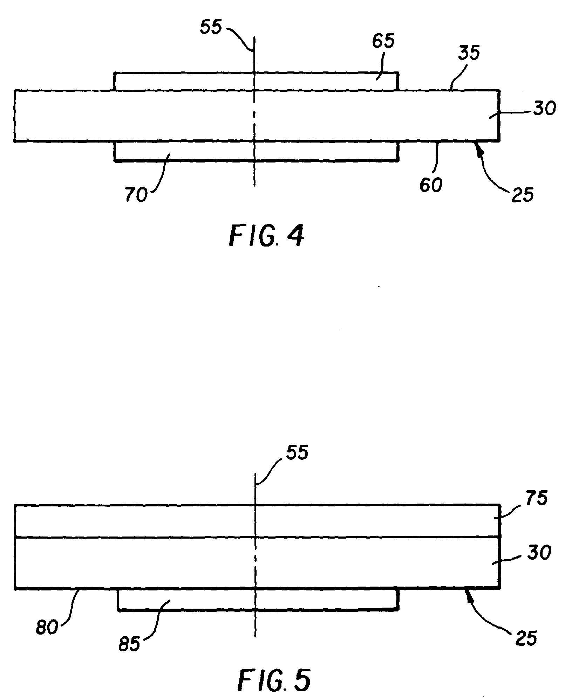

Convexity can be provided in at least one surface of the carrier element substrate in several ways. For example, the carrier element substrate can be provided with convexity in its manufacture or original design. Metallic substrates, for example, can be machined to have convexity. Alternatively, the substrate can be built up with strips of metal, stiff paper stock or other materials that are laminated, adhered or otherwise attached to the substrate surface. For example, strips of polyester film, metal or stiff paper can be bonded to the substrate surface. A preferred embodiment of this invention includes strips of resin-coated paper (such as polyolefin-coated paper) adhered with a suitable adhesive (that is, one that can stand the high temperature and pressure during lamination) to the backside of a sheet of aluminum, for example, as illustrated in FIGS. 1 and 5, described below. The convex surface of the substrate can have a smooth profile (see FIG. 3), or a step-wise profile (see for example, FIGS. 1, 2 and 4) that can have a number of variations that would be readily apparent to one skilled in the art. Whatever profile of convexity, it is essential that the convexity be symmetrical about the centerline of the substrate (or plate) in the width dimension so that the convexity approximately complements the concavity of the laminating roller nip.

Either the top or bottom surface, or both surfaces, of the substrate can have convexity, but preferably only the bottom surface is so arranged. By 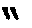 bottom*"* surface is meant the surface of the substrate opposite the surface that carries the donor and receiver elements through the laminating device.

The extent of convexity on the substrate surface can be determined by measuring substrate thickness at the centerline of the width dimension, and comparing it to the thickness of the substrate at its thinnest point at either widthwise edge. In its broadest sense, the ratio of the substrate centerline thickness to the substrate edge thickness is from 1.05:1 to 2:1, and preferably it is from 1.2:1 to 1.5:1. Most preferably, this ratio is from 1.2:1 to 1.4:1.

It is important in the preparation of a useful carrier element, then, to know approximately how much convexity is needed in a particular element to overcome the concavity in the nip of a specific set of laminating rollers. This is done by approximating the greatest width of that laminating roller nip in the following manner:

The nip formed by the laminating rollers under pressure can be measured as described below.

Matching laminating rollers are, of course, mounted in a laminating device (not shown) that can be of any conventional design. Generally, such rollers include central shafts and core heaters covered with suitable elastomeric coatings. Useful elastomeric coatings comprise, for example, silicone rubbers, fluorosilicone rubbers or polyurethanes, as are known in the art. Such materials are readily available commercially. The central shafts are used to mount the matching laminating rollers to adjustable end blocks in a laminating device. Pressure is usually applied to the laminating rollers by adjusting the end blocks inward along the plane formed by the axes of rotation of the two laminating rollers, thereby placing a load on the roller shafts. The pressure is distributed over the width of the nip formed by the deformation of the elastomeric coatings on the laminating rollers. The width of the nip is a function of the applied pressure, and the durometer reading and thickness of the elastomeric coatings.

A preferred laminating machine is described, for example, in US-A-5,573,631.

Preferred laminating rollers are 71.8 cm long, and have an additional 2.9 cm of exposed shaft on each roller end between the roller and point of attachment to the end blocks. Such laminating rollers are also 8.9 cm in diameter at 20 °C and include an elastomeric coating that is 0.6 cm thick. Both laminating rollers are typically heated during use, and have a durometer reading for the upper roller of 55 and for the lower roller of 80. Durometer readings can be measured with a commercially available machine, for example a PTC™ Durometer Model 302 (A scale), and are a measure of indentation hardness.

FIGS. 1-5 show frontal views of various embodiments of carrier plates of this invention. In each FIG., carrier plate **25** has substrate **30** which is shown with convexity on surface **35**. In FIGS. 1 and 2, convexity on surface **35** is provided by adhered sheet **40** or adhered strips **45** and **50**, respectively, symmetrically about the imaginary widthwise centerline represented by dotted line **55**. Such arrangements provide examples of what is considered herein as step-wise convexity. Other arrangements of step-wise profiles could be readily designed by a skilled worker in the art.

FIG. 3 shows carrier plate **25** having substrate **30** having a smooth profile on surface **35** symmetrically about centerline **55**.

FIG. 4 shows carrier plate **25** having substrate **30** that has convexity on both surfaces **35** and **60** provided by adhered strips **65** and **70**, respectively.

FIG. 5 shows carrier plate **25** having substrate **30** on which is disposed thermoplastic adhesive coating **75** (described below). On the bottom surface **80** of substrate **30** is adhered strip **85** to provide desired convexity on the backside of the plate symmetrically about centerline **55**.

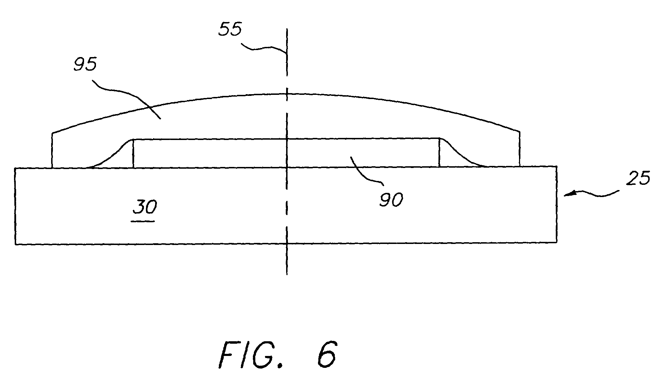

FIG. 6 shows carrier plate **25** having substrate **30** on which is disposed adhered strips **90** and **95** to provide desired convexity on the backside of the plate symmetrically about centerline **55**.

While it is not essential, it is preferred that one surface (most preferably, the top surface used for carrying the elements being laminated) have a thermoplastic adhesive coating that exhibits a desired tackiness for carrying the laminated receiver element and donor element through the laminating device. A controlled degree of surface tackiness is needed to hold such elements with sufficient tenacity to prevent irreversible dimensional changes of less than 0.01% in the receiver element (width or length) during the laminating step. Yet, if the surface of the carrier element is excessively tacky at room temperature, it will prevent the easy removal of the receiver element from the carrier element during the peeling step.

The adhesive coating can be composed of one or more thermoplastic adhesive materials including, but not limited to, polyurethanes, polyacrylates (homo- or copolymers), polymethacrylates (homo- or copolymers) and polyvinyl acetals. These coatings can also contain various fillers or plasticizers as would be well known in the art. A preferred adhesive coating comprises polyisobutyl methacrylate. The adhesive coating can be disposed over the entire substrate surface, or only in selected or random portions or patterns. Preferably, it is disposed over the entire substrate area. The adhesive coating is generally present at a coverage of from 0.5 to 200 g/m², and preferably at a coverage of from 10 to 150 g/m².

An intermediate layer can be disposed between the substrate and the adhesive coating if desired. Such a layer can be a conventional subbing layer, acrylic latex paint layer or a cushioning layer as described in EP 97101315.6.

While the carrier element of this invention is preferably used in combination with an intermediate receiver element (as described in EP 97101315.6), it would be readily apparent to one skilled in the art that the carrier element can be used in any graphic arts process wherein a carrier plate is needed to transport one or more other materials or receivers through a lamination and/or peel process.

Thus, a preferred embodiment of this invention is a carrier plate comprising an anodized aluminum substrate having on one surface thereof:
optionally, an intermediate primer or paint layer, and
a thermoplastic adhesive coating of poly(isobutyl methacrylate) disposed over the entire surface of the intermediate layer at a coverage of from 0.5 to 200 g/m²,
and the backside of the carrier plate substrate having a step-wise convex profile symmetrically about the centerline of the width dimension, wherein the ratio of the substrate centerline thickness to the substrate edge thickness in the width dimension is from 1.2:1 to 1.4:1.

Donor elements useful in the practice of this invention can utilize any of a wide variety of supports, colorants and imaging compositions. The essential requirement is that the imaging layer functions effectively to transfer the colored image to a receiver element (either intermediate or final receiver element).

The donor element comprises at least an imaging layer as described herein, but can also include additional layers as described in more detail hereinafter, including a print-out layer as described in US-A-5,374,497. Useful colorants can be either dyes or pigments and they are not restricted to a particular layer.

If desired, all of the donor elements used in the color proofing process, for example, yellow, magenta, cyan and black donor elements, can be simultaneously exposed in order to reduce the total time needed to complete the preparation of the off-press proof.

Any of a wide variety of dimensionally stable polymeric films can be utilized as the support for the donor elements. Typical of useful polymeric film supports are films of cellulose esters such as cellulose diacetate or cellulose triacetate, polystyrene, polyamide, homo- and copolymers of vinyl chloride, poly(vinylacetal), polycarbonate, homo- and copolymers of olefins, such as polyethylene and polypropylene, and polyesters of dibasic aromatic carboxylic acids with divalent alcohols, such as poly(ethylene terephthalate) and poly(ethylene naphthalate).

Polyester films, such as films of polyethylene terephthalate, have many advantageous properties, such as excellent strength and dimensional stability, which render them especially advantageous for use as supports. Such films can be coated with both a polymeric sub, for example a vinylidene chloride/methyl acrylate/itaconic acid terpolymer, and a gel sub as described in US-A-3,271,178. Such use of subbing layers is well known in the art for the purpose of rendering the polyester film receptive to coatings of functional layers.

As described hereinabove, the imaging layer utilized in the donor elements can be a photohardenable layer containing one or more photopolymerizable monomers or photocrosslinkable polymers, both of which are well known in the art. Typically, the photopolymerizable monomer is incorporated in the layer together with a compatible polymeric binder.

It is preferred to use photocrosslinkable polymers to form a photohardenable imaging layer. Particularly preferred are photocrosslinkable polymers, such as polyesters, containing the photosensitive group: 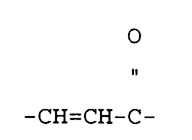 as an integral part of the polymer backbone. For example, preferred photocrosslinkable polymers are prepared from one or more compounds represented by the formulae (A)-(E) shown in US-A-5,374,497, and references noted therein. These compositions are substantially non-tacky at room temperature but have a tackifying temperature, that is, the temperature at which the composition becomes sensually tacky, of 50 °C to 200 °C.

Dyes or pigments can be utilized as the colorant in the donor elements. The colorant is typically incorporated in the imaging layer but all or part of the colorant can be incorporated in layers other than the imaging layer.

The colorant must be present in at least one layer that undergoes imagewise transfer in the lamination process. Typically, it is dispersed throughout the imaging layer. In some embodiments, more than one such layer can be included in the donor element and the colorant can be present in only one of these layers.

Essential requirements of an intermediate receiver element are that it adequately discriminate between exposed and unexposed areas of the donor elements to permit effective imagewise transfer, and that it be capable of reliably releasing the multicolor image to the final receiver element, or color proofing stock. The intermediate receiver element must also have good dimensional stability under normal handling conditions. In addition, the adhesion of the one or more layers to the support and to each other must be greater than the cohesive strength of the thermoplastic adhesive areas of the donor elements during the lamination step. In other words, the image receiving layer and other layers in the element must not delaminate from the support or from each other during the hot peeling step.

The intermediate receiver element has a suitable dimensionally stable support including but not limited to, internally sized paper base (such as that used in MATCHPRINT Proofing Base available from 3M Corp.), and polymeric films such as cellulose esters (for example, cellulose diacetate or cellulose triacetate), polystyrenes, polyamides, homo- and copolymers of vinyl chloride, polyvinylacetals, polycarbonates, polyolefins (for example, polyethylene or polypropylene), polyvinyl acetals, and polyesters of dibasic aromatic carboxylic acids with divalent alcohols [for example, poly(ethylene terephthalate) or poly(ethylene naphthalate)]. Preferably, the support is a transparent polymeric film.

Disposed on the support is an image receiving layer prepared from a suitable water-insoluble binder material that can receive an image from a donor element using the process described above, and that will not deform during the laminating steps of such transfer. Useful polymeric binder materials include, but are not limited to, vinyl acetate polymers (both homo- and copolymers), acrylate and methacrylate polymers (both homo- and copolymers, including polymers of ethyl acrylate and ethyl methacrylate), polyacrylamides, and cellulosic materials (such as hydroxyethyl cellulose). Homo- and copolymers of ethyl methacrylate are preferred. Mixtures of binder materials can be used if desired. Preferably, the binder material is transparent. Generally, the image receiving layer has a dry thickness of from 0.5 to 8 µm.

It is also desirable that the image resolution in the process of the type described in US-A-5,374,497 be significantly improved when the surface of the image receiving layer of the intermediate receiving element has an effective level of roughness as described in EP 97101315.6. Insufficient roughness gives rise to the flow problem described above. Excessive roughness causes a break up of the image and resulting loss in image density.

In a dry color proofing process, the proof is constructed by successively laminating the color records on top of one another.

The donor elements can be designed to function by cohesive failure, that is, the fracturing of a layer at a point within its thickness, or to function by adhesive failure, that is, separation at an interface between layers. Donor elements which function by cohesive failure typically require that the delamination step occur while the donor element is hot. This is referred to as a "hot peel" process. Donor elements which function by adhesive failure permit carrying out of the delamination step after the donor element has cooled. This is referred to as a "cold peel" process.

In the process of US-A-3,622,320, the peel-apart step is carried out while the donor element is still hot from its passage through the heated rollers of the laminator. The colored imaging layer fractures as a result of cohesive failure, with such fracturing usually taking place near the mid-point of its thickness. Thus, only a portion of the total colorant is transferred to the receiver and a portion is left behind with the donor element to be discarded.

The laminating device used in the method of this invention can be any suitable device that provides the necessary heat and pressure with laminating rollers to transfer the images from the imagewise exposed donor elements to the intermediate receiver element.

Laminating devices for use in laminating photosensitive elements employed in color proofing are well known in the art and are described, for example, in US-A-4,659,927 and US-A-5,075,722. Another useful laminating device is described in US-A-5,573,631.

A suitable transport speed in the laminating device ranges from 0.2 to 1.5 cm/sec. Typical temperatures in the laminating roller nip at the point where lamination occurs are generally in the range of from 75 °C to 115 °C.

Lamination pressures suitable for use in the method of this invention can be readily determined in terms of "nip pressure" as measured in centimeters. As used herein, the term "nip pressure" refers to the width over which the heated rubber rollers of the laminating device are in intimate contact. This can be determined by inserting the donor element, while in superposed contact with a low density polyethylene film, between the heated rubber rollers, turning off the drive motor that turns the rollers, and locking the rollers together. A clearly visible stripe forms where the donor element and the low density polyethylene film were in intimate contact. The width of this stripe is measured as the "nip pressure." In the method of this invention, it is preferred that the "nip pressure" be in the range of from 0.3 to 1.2 cm.

In some instances the donor elements are utilized in a process which employs two lamination procedures, namely, (1) successive laminations from the donor elements to an intermediate receiver element to form the full color image followed by (2) lamination of the intermediate receiver element having the full color image to a final receiver element. In each instance, a choice of using a hot peel or a cold peel exists, as does a choice of a manual peel or an automatic peel. A useful combination, for example, is one employing an automatic hot peel for donor-intermediate receiver delamination and a manual cold peel for intermediate receiver element-final receiver element delamination. Many other combinations are, of course, also feasible. The carrier element of this invention can be used at any stage in such a process.

The method of this invention is greatly superior to the color proofing processes of the prior art in that it is simple, inexpensive, and provides for very accurate image registration by operators with minimal skill requirements.

Many other variations and embodiments that are not illustrated are within the scope of the present invention since only the essential requirements of the invention are described herein. In defining various numerical parameters, the term "about" is a clear, but flexible modifier meaning "approximately" because most parameters cannot be set with an exact limit. The degree of variation encompassed by the term will depend upon the specific parameter and the limits of its measurement.

The invention is further illustrated by the following examples of its practice. Unless otherwise indicated, percentages are by weight and amounts per area are dry coverage.

### Examples 1 and 2:

Two carrier plates of this invention were prepared in the following manner:

A 0.38 mm sheet of anodized aluminum, 72.4 cm wide, was uniformly coated with a 0.025 mm layer of a conventional acrylic latex white paint (having a glass transition temperature less than the conventional lamination temperature). To this painted surface, was applied several coatings (to total 0.127 mm thickness) of a 80:20 (w/w) blend of ELVACITE 2045 poly(isobutyl methacrylate) and benzyl isooctyl phthalate plasticizer to provide a uniform thermoplastic adhesive layer (71.1 cm wide) with a total coverage of about 129 g/m².

To the backside (unpainted side) of the anodized aluminum substrate was adhered a strip (42 cm wide, 0.178 mm thickness) of polyolefin-coated paper, using ELVACITE 2045 as the adhesive to provide a carrier plate of this invention (Example 1). This strip was symmetrical about the centerline in the width dimension.

A second carrier plate of this invention (Example 2) was similarly prepared as Example 1 except that to the backside of the substrate was applied, in succession, a strip (35.6 cm wide, 0.020 mm thickness) of ELVACITE 2045 adhesive layer, and a strip (56 cm, 0.178 mm thickness) of polyolefin-coated paper, both symmetrically about the centerline of the width dimension.

Two control carrier plates were prepared for comparison.

Control A comprised a sheet (0.51 mm thickness) of anodized aluminum (72.4 cm wide), painted as described above uniformly across the sheet width.

Control B was like Control A, except that the anodized aluminum sheet was only 0.38 mm thick, and the painted surface was coated to provide a thermoplastic adhesive layer (0.127 mm) as described above.

Two conventional matching laminating rollers that are each 8.9 cm in diameter and 71.8 cm long (an additional 2.9 cm exposed shaft at each end) at 20 °C were evaluated for nip size under pressure. Each roller had an elastomeric coating that was 0.635 cm in thickness. When heated to 110 °C, the durometer reading of the upper roller was 55, and that of the lower roller was 80. These rollers were put under 11 mm nip pressure at 110 °C, at plate edge, for these evaluations.

The nip width was measured at various points along the roller length (cm from roller end) as described above. The resulting nip width for each carrier plate described above is shown in the following TABLE I:

**TABLE I**

| **NIP WIDTH (mm)** | | | | | | | | | | | | | | |
|---|---|---|---|---|---|---|---|---|---|---|---|---|---|---|
| **Carrier plate** | **Roller width (cm)** | | | | | | | | | | | | | |
| | **0** | **5** | **10** | **15** | **20** | **25** | **30** | **36** | **41** | **46** | **51** | **56** | **61** | **66** |
| Control A | 11 | 11 | 11 | 10 | 9 | 9 | 8 | 8 | 9 | 9 | 10 | 11 | 11 | 11 |
| Control B | 11 | 11 | 11 | 10 | 9 | 9 | 8 | 8 | 9 | 9 | 10 | 11 | 11 | 11 |
| Example 1 | 11 | 11 | 10 | 11 | 11 | 10 | 10 | 10 | 10 | 11 | 11 | 10 | 11 | 11 |
| Example 2 | 11 | 11 | 11 | 11 | 11 | 11 | 10 | 10 | 10 | 11 | 11 | 11 | 11 | 11 |

When an image is transferred from a donor element to an intermediate receiver element using the Control A and B, under the conditions that the data in TABLE I were obtained, an undesirable 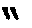 bow*"* in the resulting image is seen. That is, the center of the image is lengthwise displaced on the carrier plate relative to the image edges. The length of the 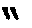 bow*"* or displacement (in mm) of the image center were found to be as follows for the carrier plates describes above:

**TABLE II**

| **Carrier Plate** | 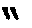 **Bow*"* or Displacement (mm)** |
|---|---|
| Control A | 0.18 |
| Control B | 0.20 |
| Example 1 | 0 |
| Example 2 | 0 |

As can be seen from these data, the degree of concavity of the laminating roller nip directly relates to the magnitude of the 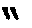 bow*"* or image displacement. The amount of image displacement observed with Controls A and B would make registration of subsequent images, for example, in the preparation of a four-color proof image, very difficult if not impossible.

When the concavity of the roller nip was complemented by convexity in the carrier plate, as in Examples 1 and 2, the 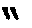 bow*"* or image displacement was greatly reduced.

### Example 3: Method of Making A Prepress Color Proof

The carrier plate of this invention was used in the method of this invention in the following manner:

An image receiving element was prepared by coating the following layers, in order, on a biaxially oriented poly(ethylene terephthalate) support:
1) a cushioning layer composed of poly(vinyl acetate-co-crotonic acid) (20.5 g/m², VINAC ASB-516 from Air Products Co.); and
2) a roughened image receiving layer composed of amorphous silica matting agent (0.22 g/m², SYLOID 244X-1669 from Grace-Davidson) dispersed in poly(ethyl methacrylate) binder (1.08 g/m², ELVACITE 2042 polymer from ICI Americas). This matting agent provided at least 480 peaks/mm² which peaks had a height between 0.1 and 1.0 µm.

The cushioning layer was prepared by coating the noted polymer out of methyl ethyl ketone onto the polyester film support using conventional means, and drying. Its dry thickness was about 19 µm.

The image receiving layer was prepared by dispersing the matting agent (0.8%) with a dispersing aid, FC-171 fluoroaliphatic polymeric esters (0.025%, 3M Corp.) in isopropyl alcohol. The dispersion is then added to a solution of the noted polymer binder (4%) in a solvent mixture of isopropyl alcohol, methyl ethyl ketone and methyl isobutyl ketone (80:10:10 volume ratio), coated on the cushioning layer using conventional equipment, and dried. The dry thickness of this layer averaged 1.2 µm.

This intermediate receiver element was placed on the carrier plate described of Example 1, backside down. A first, imagewise exposed conventional positive-working, photohardenable donor element having black pigment as described in US-A-5,374,497 was placed, emulsion-to-emulsion, in intimate contact with the intermediate receiver element on the carrier plate. The complete package of elements and carrier plate was passed through the nip of a conventional two-roller laminating device having rollers as described in Examples 1-2. This device is described, for example, in US-A-5,573,631. The transport speed through the device was 0.423 cm/sec, and the lamination temperature in the roller nip was 90-95 °C.

As the laminated packaged exited the nip, the donor element was peeled (while hot) from the intermediate receiver element, leaving behind on the intermediate receiver layer, the pigmented top portion of the unexposed areas of the donor element (that is, a black image). This transferred portion of the donor element was then uniformly exposed to actinic radiation, the exposure being at least 33% of the original exposure of the donor element.

A second imagewise exposed donor element (containing cyan pigment) was similarly placed in contact with the intermediate receiver element carrying the first transferred image. This donor element comprised a print-out image useful for aligning the element on the intermediate receiver element as described in US-A-5,374,497. Lamination, peeling and post-exposure were carried out again as described above.

Similarly, third and fourth imagewise exposed donor elements (containing magenta and yellow pigments, respectively) were aligned with the intermediate receiver layer on the carrier plate, laminated, and color images were transferred as described above. The result was a four-color image on the intermediate receiver layer.

When the intermediate receiver element and carrier plate were cooled to room temperature, the intermediate receiver element was peeled from the carrier plate. It was then placed emulsion-to-emulsion in contact with a conventional final receiver element (having a paper stock support with an adhesive layer) on a conventional non-adhesive final carrier plate which also comprised a hinged cover sheet of polyethylene terephthalate.

This package of materials was passed through the nip of a conventional two-roller laminator device at a transport speed of 0.423 cm/sec with a lamination temperature of 90-95 °C in the roller nip. After removing the final receiver element-intermediate receiver element laminate from the carrier plate (and cover sheet), and cooling to room temperature, the support of the intermediate receiver element was peeled away to provide the desired prepress color proof.

## Claims

1. A carrier element useful in a dry color proofing process in which a color image is transferred from a donor element to a receiver element by laminating the donor element to the receiver element at selected lamination temperature and pressure in a laminating device having matching laminating rollers that define a laminating nip, followed by peeling the laminated donor element from the receiver element,
the carrier element comprising a relatively stiff substrate having a width dimension,
the element characterized wherein the substrate has at least one surface thereof that is convex symmetrically about the centerline of the width dimension, wherein the ratio of the centerline thickness to the thickness at the edge of the substrate in the width dimension is from 1.05:1 to 2:1.

2. The element as claimed in claim 1 wherein the substrate further has on one surface thereof a thermoplastic adhesive coating, the adhesive coating having a glass transition temperature that is less than the lamination temperature but is sufficiently high to provide low surface tackiness at room temperature, and the adhesive coating also exhibiting sufficient surface tackiness at the lamination temperature to prevent irreversible dimensional change of the receiver element during the lamination step.

3. The element as claimed in claim 2 wherein the thermoplastic adhesive coating exhibits sufficient surface tackiness at the lamination temperature to prevent irreversible dimensional change greater than 0.01% in the receiver element during the laminating step.

4. The element as claimed in either claim 2 or 3 wherein the adhesive coating comprises an acrylate or methacrylate polymer, a polyvinyl acetal, or a polyurethane.

5. The element as claimed in any of claims 1 to 4 wherein both front and back surfaces of the substrate are convex symmetrically about the centerline of the width dimension.

6. The element as claimed in any of claims 1 to 5 wherein the ratio of the substrate centerline thickness to the substrate edge thickness in the width dimension is from 1.2:1 to 1.5:1.

7. The element as claimed in any of claims 1 to 6 wherein the convex surface has a step-wise profile.

8. The element as claimed in any of claims 1 to 6 wherein the convex surface has a smooth profile.

9. A method for preparing a prepress color proof in which colored images are successively transferred from donor elements to a receiver element by a process of lamination so as to form a multicolor image on the receiver element, the method comprising the steps of:
A) providing a receiver element,
B) providing at least two imagewise-exposed, multilayer donor elements, each of which contains a colorant that undergoes imagewise transfer to the receiver element, and
C) transferring a color image in either exposed or unexposed areas of each of the donor elements, by:
laminating at selected lamination temperature and pressure, in succession and register, each of the donor elements to the receiver element in a laminating device, the laminating device having matching laminating rollers forming a laminating nip,
followed by peeling each of the laminated donor elements from the receiver element,
wherein each of the donor elements and the receiver element are carried through the laminating nip of the laminating device with the carrier element of any of claims 1 to 8.

10. The use of the carrier element as claimed in any of claims 1 to 8.
